# EUROPEAN PATENT APPLICATION

(11) **EP 4 780 159 A1**
(43) Date of publication of application: **22.07.2026**
(21) Application number: 25211405.3
(22) Date of filing: 27.10.2025
(51) Int. Cl.: H10B 43/27

(54) **NONVOLATILE MEMORY DEVICE, ELECTRONIC DEVICE INCLUDING THE SAME AND METHOD OF MANUFACTURING THE NONVOLATILE MEMORY DEVICE**

(30) Priority: 17.01.2025 KR 20250007544
(71) Applicant: Samsung Electronics Co., Ltd., Suwon-si, Gyeonggi-do 16677 (KR)
(72) Inventor: PARK, Jinjoo, 16678 Suwon-si (KR); LEE, Minhyun, 16678 Suwon-si (KR); LEEM, Youngchul, 16678 Suwon-si (KR); JANG, Seonghun, 16678 Suwon-si (KR); CHOI, Seokhoon, 16678 Suwon-si (KR)
(74) Representative: Elkington and Fife LLP

(57) **Abstract**

Provided are a nonvolatile memory device, an electronic device including the same, and a method of manufacturing the nonvolatile memory device. A nonvolatile memory device includes a substrate, a plurality of separators and a plurality of gate electrodes alternately stacked in a first direction perpendicular to the substrate, the plurality of separators and the plurality of gate electrodes including a channel hole passing therethrough in the first direction, a charge blocking layer inside the channel hole, a charge tunneling layer inside the charge blocking layer, a channel layer inside the charge storage layer, and a plurality of charge storage particles spaced apart from each other between the charge blocking layer and the charge tunnel layer.

## Description

### FIELD OF THE INVENTION

The disclosure relates to nonvolatile memory devices capable of reducing charge loss, electronic devices including the same, and methods of manufacturing the nonvolatile memory device.

### BACKGROUND OF THE INVENTION

As hard disks are replaced by solid state drives (SSDs), NAND flash memory devices, which are nonvolatile memory devices, are widely used. With the miniaturization and higher integration of nonvolatile memory devices, vertical NAND flash memory devices in which a number of memory cells are stacked in a direction perpendicular to a substrate are being developed.

Recently, as higher integration and/or lower power are required or desired, interest in addressing issues such as relatively high program/erase voltage, relatively small memory window, and/or relatively short data retention is increasing. In nonvolatile memory devices, charge transfer between memory cells may occur due to an increase in the number of stacked memory cells and a decrease in height of the memory cells, and such charge transfer may deteriorate charge retention of the memory cells.

### SUMMARY OF THE INVENTION

Provided are nonvolatile memory devices that facilitate charge transfer between charge storage particles and a channel layer, electronic devices including the same, and methods of manufacturing the nonvolatile memory device.

Provided are nonvolatile memory devices capable of performing relatively easy charge transfer that may reduce charge loss between charge storage particles and a gate electrode, electronic devices including the same, and methods of manufacturing the nonvolatile memory device.

Additional aspects will be set forth in part in the description which follows and, in part, will be apparent from the description, or may be learned by practice of the presented example embodiments of the disclosure.

According to an example embodiment of the disclosure, a nonvolatile memory device includes a substrate, a plurality of separators and a plurality of gate electrodes alternately stacked in a first direction perpendicular to a surface of the substrate, the plurality of separators and the plurality of gate electrodes including a channel hole passing therethrough in the first direction, a charge blocking layer inside the channel hole, a plurality of charge storage particles inside the charge blocking layer and each having an asymmetric shape with respect to the first direction, a charge tunneling layer inside the charge blocking layer and covering the plurality of charge storage particles, and a channel layer inside the charge tunneling layer.

In addition, each of the plurality of charge storage particles may be in contact with the charge blocking layer and may be spaced apart from the channel layer.

Further, a first gap between the plurality of charge storage particles and the plurality of gate electrodes may be constant, and a second gap between the channel layer and at least one of the plurality of charge storage particles may not be constant.

In addition, the second gap between the channel layer and the at least one of the plurality of charge storage particles may gradually decrease and then gradually increase from a lower end of the at least one of the plurality of charge storage particles to an upper end of the at least one of the plurality of charge storage particles.

In addition, at least one of the plurality of charge storage particles includes a first curved surface facing the charge blocking layer and a second curved surface facing the channel layer, and a first radius of curvature of the first curved surface may be different from a second radius of curvature of the second curved surface.

In addition, the second radius of curvature of the second curved surface may be smaller than the first radius of curvature of the first curved surface.

In addition, at least one of the plurality of charge storage particles may have a shape of a truncated sphere.

In addition, a length of each of the plurality of charge storage particles may be less than a thickness of the gate electrode in the first direction.

Furthermore, the plurality of charge storage particles may be arranged to be spaced apart from each other in the first direction.

In addition, an angle between the charge blocking layer and an outer circumferential surface of at least one of the plurality of charge storage particles above may be in a range between 30 degrees and 150 degrees.

In addition, an inner side surface of the charge tunneling layer may have a curved shape corresponding to the plurality of charge storage particles.

In addition, an inner side surface of the channel layer may have a curved shape corresponding to the plurality of charge storage particles.

In addition, at least one of the plurality of charge storage particles may include at least one of semiconductor, metal, MO (M is metal), or MAO (M is metal), where A may include at least one of Si or Al.

The semiconductor may include Si or Ge.

In addition, the M may include at least one of Hf, Ti, Zr, U, Th, Cr, Ga, V, Sc, Lu, Yb, Er, Ho, Dy, Gd, Eu, Sm, Y, Nd, Ce, La, Ni, Mg, Cu, Zn, Co, Fe, Mn, Ca, Eu, Sr, Sm, Cu, Ru, Pt, Mo, W, Co, or Pd.

According to another example embodiment of the disclosure, an electronic device includes a nonvolatile memory device, and a memory controller configured to control the nonvolatile memory device so that data is read from and/or data is written to the nonvolatile memory device, wherein the nonvolatile memory device includes a substrate, a plurality of separators and a plurality of gate electrodes alternately stacked in a first direction perpendicular to a surface of the substrate, the plurality of separators and the plurality of gate electrodes including a channel hole passing therethrough in the first direction, a charge blocking layer located on an inner side of the channel hole, a plurality of charge storage particles inside the charge blocking layer and each having an asymmetric shape with respect to the first direction, a charge tunneling layer inside the charge blocking layer and covering the plurality of charge storage particles, and a channel layer inside the charge tunneling layer.

According to another example embodiment of the disclosure, a method of manufacturing a nonvolatile memory device includes alternately forming a plurality of first insulating material layers and a plurality of second insulating material layers on a substrate, forming a channel hole penetrating the plurality of first insulating material layers and the plurality of second insulating material layers in a first direction perpendicular to the surface of the substrate, forming a charge blocking layer inside the channel hole, forming a plurality of charge storage particles having an asymmetric shape in a direction perpendicular to the substrate inside the charge blocking layer, forming a charge tunneling layer covering the plurality of charge storage particles inside the charge blocking layer, and forming a channel layer inside the charge tunneling layer.

The method further includes replacing the plurality of second insulating material layers with a plurality of gate electrodes, respectively, wherein a first gap between the plurality of charge storage particles and the plurality of gate electrodes corresponding to the plurality of charge storage particles may be constant, and a second gap between the channel layer and at least one of the plurality of charge storage particles may not be constant.

In addition, the second gap between the channel layer and the at least one of the plurality of charge storage particles may gradually decrease and then gradually increase from a lower end of the at least one of the plurality of charge storage particles to an upper end of the at least one of plurality of charge storage particles.

In addition, at least one of the plurality of charge storage particles includes a first curved surface facing the charge blocking layer and a second curved surface facing the channel layer, and a first radius of curvature of the first curved surface is greater than a second radius of curvature of the second curved surface.

In addition, at least one of the plurality of charge storage particles may have a shape of a truncated sphere.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a cross-sectional view illustrating a schematic structure of a nonvolatile memory device according to an example embodiment;
FIG. 2 is a perspective view illustrating a schematic structure of a memory string included in the nonvolatile memory device of FIG. 1;
FIG. 3 illustrates a circuit diagram including the nonvolatile memory device of FIG. 1 according to an example embodiment;
FIGS. 4A to 4H are reference views illustrating a method of manufacturing a nonvolatile memory device according to an example embodiment;
FIG. 5 is a cross-sectional view illustrating a schematic structure of a nonvolatile memory device according to another embodiment;
FIG. 6 is a cross-sectional view illustrating a schematic structure of a nonvolatile memory device according to another example embodiment;
FIG. 7 is a cross-sectional view illustrating a nonvolatile memory device including a double charge blocking layer according to an example embodiment;
FIG. 8 is a cross-sectional view illustrating a nonvolatile memory device further including a diffusion barrier layer according to an example embodiment;
FIG. 9 is a cross-sectional view illustrating a nonvolatile memory device including a curved charge blocking layer and a channel layer according to an example embodiment;
FIG. 10 is a cross-sectional view illustrating a nonvolatile memory device according to an example embodiment;
FIG. 11 is a schematic block diagram of a display driver integrated circuit (IC) (DDI) and a display device including the DDI according to an example embodiment;
FIG. 12 is a block diagram illustrating an electronic device according to an example embodiment;
FIG. 13 is a block diagram illustrating an electronic device according to an example embodiment;
FIG. 14 is a conceptual diagram schematically illustrating a device architecture applicable to an electronic device according to an example embodiment; and
FIG. 15 is a conceptual diagram schematically illustrating a device architecture applicable to an electronic device according to another example embodiment.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, some example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a nonvolatile memory device, an electronic device including the same, and a method of manufacturing a nonvolatile memory device according to various example embodiments will be described in detail with reference to the accompanying drawings. In the following drawings, the same reference numerals refer to the same components, and the size of each component in the drawings may be exaggerated for clarity and convenience of description.

Singular expressions include plural expressions unless the context clearly means otherwise. In addition, when a part "contains" a component, this means that it may contain other components, rather than excluding other components, unless otherwise stated. In addition, the size or thickness of each component in the drawing may be exaggerated for clarity of explanation. Additionally, when a desired (or alternatively, predetermined) material layer is described as being on a substrate or another layer, the material layer may exist in direct contact with the substrate or the other layer, or another third layer may exist in between. In addition, because the materials constituting each layer in the example embodiments below are only examples, other materials may be used.

Furthermore, the terms "unit", "module" or the like mean a unit that processes at least one function or operation, which may be implemented in hardware or software or implemented in a combination of hardware and software.

The specific implementations described in the present example embodiments are examples and do not limit the technical scope in any way. For simplicity of the specification, descriptions of conventional electronic configurations, control systems, software, and other functional aspects of the systems may be omitted.

In addition, the connection or connection members of lines between the components shown in the drawings illustratively represent functional connection and/or physical or circuit connections, and may be replaceable or represented as various additional functional connections, physical connections, or circuit connections in an actual device.

The use of the term "the" and similar indicative terms may correspond to both singular and plural.

Operations constituting the method may be performed in an appropriate order unless there is a clear statement that the operations should be performed in the order described. In addition, the use of all illustrative terms (e.g., etc.) is simply intended to detail technical ideas and, unless limited by the claims, the scope of rights is not limited due to the terms.

An expression such as "at least one" that precedes an element list limits the entire element list and does not limit individual elements in the list. For example, expressions such as "at least one of A, B and C" or "at least one selected from the group consisting of A, B, and C" may be interpreted as A only, B only, C only, or a combination of two or more of A, B, and C, such as ABC, AB, BC, and AC.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When "about" or "substantially" is used in connection with a numerical value, the relevant numerical value may be interpreted to include manufacturing or operating variations (e.g., ±10 %) around the specified numerical value. In addition, when the terms "generally" and "substantially" are used in relation to a geometric shape, it may be intended that a geometric precision is not required, and the tolerance for the shape is within the scope of this present disclosure. In addition, regardless of whether a numerical value or shape is limited to "about" or "substantially," these values and shapes may be interpreted as including manufacturing or operating deviations (e.g., ±10 %) around the specified numerical value.

The terms "first", "second", etc. may be used to describe various components, but the components should not be limited by terms. The terms are used only for the purpose of distinguishing one component from other components.

The use of all examples or illustrative terms is simply to describe technical ideas in detail, and the scope is not limited due to these examples or illustrative terms unless the scope is limited by the claims.

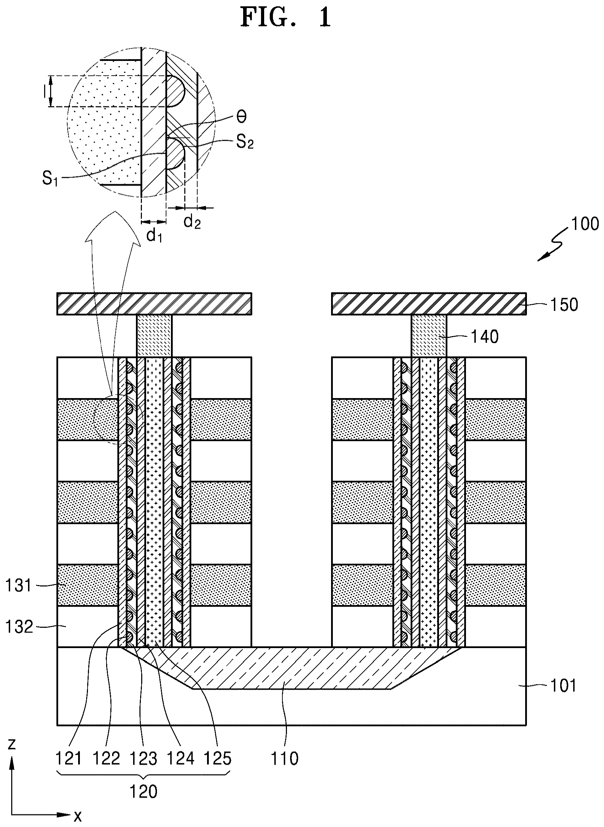

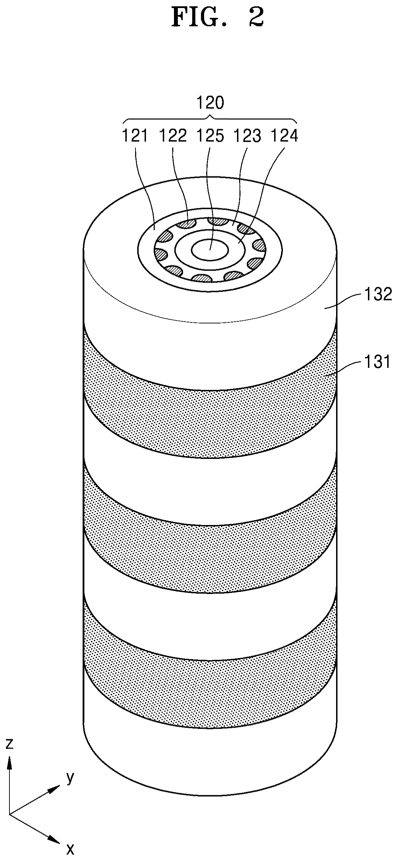

FIG. 1 is a cross-sectional view illustrating a schematic structure of a nonvolatile memory device 100 according to an example embodiment, and FIG. 2 is a perspective view illustrating a schematic structure of a memory string included in the nonvolatile memory device 100 of FIG. 1.

Referring to FIGS. 1 and 2, a plurality of cell strings CS are formed on a substrate 101. The substrate 101 may include a silicon material doped with first type impurities. For example, the substrate 101 may include a silicon material doped with p-type impurities. For example, the substrate 101 may be a p-type well (e.g., a pocket p-well). Hereinafter, it is assumed that the substrate 101 includes p-type silicon. However, the substrate 101 is not limited to p-type silicon.

A common source region 110 is provided on the substrate 101. For example, the common source region 110 may have a second type that is different from that of the substrate 101. For example, the common source region 110 may have an n-type. Hereinafter, it is assumed that the common source region 110 is n-type. However, the common source region 110 is not limited to n-type, and may be p-type.

The cell string CS includes a cylindrical channel hole 120, a plurality of gate electrodes 131, and a plurality of separators 132, wherein the plurality of gate electrodes 131 and the plurality of separators 132 surround the cylindrical channel hole 120. The plurality of gate electrodes 131 and the plurality of separators 132 may be alternately stacked in the vertical direction (Z-axis direction). Because the plurality of gate electrodes 131 are stacked in a direction perpendicular to the surface of the substrate 101, the nonvolatile memory device 100 of FIG. 1 may be referred to as a vertical nonvolatile memory device 100.

The gate electrodes 131 may include a metal material, or a silicon material doped at a relatively high concentration. The separators 132 may serve as spacers for insulation between conductive layers such as gate electrodes. The separators 132 may include various insulating materials such as silicon oxide and silicon nitride.

The channel hole 120 is formed through the gate electrodes 131 and the separators 132. Here, the channel hole 120 may be formed to extend in a direction perpendicular to the surface of the substrate 101 (e.g., the Z-axis direction in FIG. 2). The channel hole 120 may be formed to have a circular cross section.

The channel hole 120 may accommodate a plurality of layers therein. A charge blocking layer 121 may be arranged inside the channel hole 120, a plurality of charge storage particles 122 may be arranged inside the charge blocking layer 121, a charge tunneling layer 123 covering the plurality of charge storage particles 122 may be arranged inside the charge blocking layer 121, and a channel layer 124 and a pillar 125 may be arranged inside the charge tunneling layer 123.

Here, when a desired (or alternatively, predetermined) voltage is applied to the gate electrode 131, charges flowing in the channel layer 124 may pass through the charge tunneling layer 123 and be captured in the charge storage particles 122, thereby storing information.

The charge blocking layer 121 may extend in a direction perpendicular to the surface of the substrate 101. The charge blocking layer 121 may be provided to have a cylindrical shape._The charge blocking layer 121 may be provided on the inner wall (e.g., the inner boundary or the inner side boundary) of the channel hole 120 to be in contact with the gate electrodes 131 and the separators 132. The charge blocking layer 121 may perform a barrier function of blocking or preventing a charge transfer between the charge storage particles 122 and the gate electrodes 131. A first surface of the charge blocking layer 121 may be in contact with the charge storage particles 122, and a second surface facing the first surface may be in contact with the gate electrodes 131. The charge blocking layer 121 may include, for example, silicon oxide or metal oxide, but example embodiments are not limited thereto.

The plurality of charge storage particles 122 may be spaced apart from each other on the side surface of the charge blocking layer 121. Because the plurality of charge storage particles 122 are spaced apart from each other, it is possible to reduce electric charge loss to the side. A length of each of the plurality of charge storage particles 122 in a direction perpendicular to the surface of the substrate 101 (e.g., the Z-axis direction) may be less than or equal to a thickness of each of the gate electrodes 131. For example, a length of each of the plurality of charge storage particles 122 in a direction perpendicular to the surface of the substrate 101 (e.g., the Z-axis direction) may be equal to or less than 1/2 of a thickness of each of the gate electrodes 131. In some example embodiments, the longest length of each of the plurality of charge storage particles 122 in a direction perpendicular to the surface of the substrate 101 (e.g., the Z-axis direction) may be about 10 nm or less. A gap between neighboring charge storage particles 122 among the plurality of charge storage particles 122 may be about 1 nm or more. For example, two or more charge storage particles 122 may be arranged on one gate electrode 131.

Each of the plurality of charge storage particles 122 may have an asymmetric shape with respect to a direction perpendicular to the surface of the substrate 101 (e.g., the Z-axis direction). While a gap d1 between the plurality of charge storage particles 122 and the plurality of gate electrodes 131 is constant, a gap between at least one of the plurality of charge storage particles 122 and the channel layer 124 may not be constant. A gap between the channel layer 124 and at least one of the plurality of charge storage particles 122 may gradually decrease and then gradually increase again from the lower ends of the charge storage particles 122 to the upper ends of the charge storage particles 122. A minimum gap d2 between the charge storage particles 122 and the channel layer 124 may be less than or equal to about 3 nm.

In some example embodiments, at least one of the plurality of charge storage particles 122 includes a first curved surface S1 facing the charge blocking layer 121 and a second curved surface S2 facing the channel layer 124, and radii of curvature of the first curved surface S1 and the second curved surface S2 may be different from each other. A radius of curvature of the second curved surface S2 may be less than a radius of curvature of the first curved surface S1. In addition, at least one of the plurality of charge storage particles 122 may have a shape of a truncated sphere. For example, at least one of the plurality of charge storage particles 122 may have a hemispherical shape. That is, an angle θ between the charge blocking layer 121 and the outer circumferential surface of the charge storage particles 122 may be about 90 degrees.

The charge storage particles 122 may store introduced charges. Charges (e.g., electrons) present in the channel layer 124 may be introduced into the charge storage particles 122 by a tunneling effect or the like. Charges introduced into the charge storage particles 122 may be fixed to the charge storage particles 122.

Because the charge storage particles 122 have a surface adjacent to the channel layer 124 more convexly formed than a surface adjacent to the gate electrode 131, an electric field may be more concentrated between the charge storage particles 122 and the channel layer 124. Thus, the flow of charges between the channel layer 124 and the charge storage particles 122 may be relatively easy, while the flow of charges between the channel layer 124 and the gate electrodes 131 may be relatively difficult.

The charge storage particles 122 may include amorphous oxynitride. Materials of the charge storage particles 122 will be described later.

The charge tunneling layer 123 is a layer where charge tunneling is performed, and may include, for example, silicon oxide or metal oxide, but example embodiments are not limited thereto.

The channel layer 124 may include a semiconductor material doped with first type impurities. The channel layer 124 may include a silicon material doped in the same type as the substrate 101, and for example, when the substrate 101 includes a p-type-doped silicon material, the channel layer 124 may also include a p-type-doped silicon material. In some example embodiments, the channel layer 124 may also include a material, such as Ge, IGZO, GaAs, or the like. The channel layer 124 may be provided to have a cylindrical shape.

A pillar 125 may be arranged inside the channel layer 124. The pillar 125 may include, for example, silicon oxide or air, but example embodiments are not limited thereto.

The channel layer 124 may be in contact with the doping region, that is, the common source region 110.

A drain 140 may be provided on the channel hole 120. The drain 140 may include a silicon material doped with second type impurities. For example, the drain 140 may include an n-type-doped silicon material.

A bit line 150 may be provided on the drain 140. In some example embodiments, the drain 140 and the bit line 150 may be connected to each other through contact plugs.

Each of the gate electrodes 131, the separator 132 and the channel layer 124 facing the gate electrode 131 in the horizontal direction (X-axis direction) form a memory cell MC. That is, the memory cell MC has a circuit structure in which a transistor including a gate electrode 131, a separator 132, and a channel layer 124 and charge storage particles 122 are connected or are present.

The memory cells MC are continuously arranged in the vertical direction (Z direction) to form a cell string CS. The nonvolatile memory device 100 has a structure in which cells are connected to each other in the vertical direction.

At least one of the charge storage particles 122 according to an example embodiment may have a relatively high dielectric constant or a relatively high charge storage density. The charge storage particles 122 have a field effect enhanced by a relatively high dielectric constant, and charge storage efficiency may be improved by a relatively high charge storage density.

The charge storage particles 122 may include a ternary or more material to enhance a storage site. For example, the charge storage particles 122 may include a matrix material with a relatively high storage density and a crystallization control material that controls the crystallization of the matrix material. The matrix material may include oxynitride. For example, the matrix material may include at least one of aluminum oxynitride or silicon oxynitride. The matrix material includes nitrides, as well as oxides, which may implement relatively low formation energy and/or relatively deep trap charge states while having intrinsic defects caused by nitrogen vacancies.

For example, each of the charge storage particles 122 may include AₓB_{y}O_{z}N_{(1-x-y-z)} (A and B are different elements, at least one of A or B is a metal element, O is oxygen, N is nitrogen, x≥0.3, 0<y≤0.1, and z≥x). Here, element A may be a component of the matrix material, and element B may be a component of the crystallization control material. For example, element A may be any one of aluminum (Al), hafnium (Hf), zirconium (Zr), or silicon (Si), and element B may be any one of aluminum (Al), hafnium (Hf), zirconium (Zr), silicon (Si), boron (B), or gallium (Ga).

In the charge storage particles 122, the content of the element A may be about 30 at% or more, about 31 at% or more, about 32 at% or more, about 33 at% or more, about 34 at% or more, about 35 at% or more, about 37 at% or less, about 38 at% or less, about 39 at% or less, or about 40 at% or less. The content of the element B may be greater than 0 at%, greater than or equal to about 1 at%, greater than or equal to about 2 at%, greater than or equal to about 3 at%, greater than or equal to about 4 at%, less than or equal to about 5 at%, less than or equal to about at%, less than or equal to about 7 at%, less than or equal to about 8 at%, less than or equal to about 9 at%, or less than or equal to about 10 at%. The content of the oxygen element may be greater than or equal to the content of the element A, and, for example, the content of the oxygen element may be about 30 at% or more, about 35 at% or more, about 45 at% or more, about 45 at% or less, about 50 at% or less, about 55 at% or less, or about 60 at% or less.

Each of the charge storage particles 122 may further include carbon. For example, each of the charge storage particles 122 may include AₓB_{y}O_{z}C_{w}N_{(1-x-y-z-w)} (A and B are different elements, at least one of A or B is a metal element, O is oxygen, C is carbon, N is nitrogen, x≥0.3, 0<y≤0.1, z≥x, and 0< w ≤y). Here, element A may be a component of the matrix material, and element B may be a component of the crystallization control material. For example, element A may be any one of aluminum (Al), hafnium (Hf), zirconium (Zr), or silicon (Si), and element B may be any one of aluminum (Al), hafnium (Hf), zirconium (Zr), silicon (Si), boron (B), or gallium (Ga).

In the charge storage particles 122, the content of the element A may be about 30 at% or more, about 31 at% or more, about 32 at% or more, about 33 at% or more, about 34 at% or more, about 35 at% or more, about 37 at% or less, about 38 at% or less, about 39 at% or less, or about 40 at% or less. The content of the element B may be greater than 0 at%, greater than or equal to about 1 at%, greater than or equal to about 2 at%, greater than or equal to about 3 at%, greater than or equal to about 4 at%, less than or equal to about 5 at%, less than or equal to about 6 at%, less than or equal to about 7 at%, less than or equal to about 8 at%, less than or equal to about 9 at%, or less than or equal to about 10 at%. The content of the oxygen element may be greater than or equal to the content of the element A, and, for example, the content of the oxygen element may be about 30 at% or more, about 35 at% or more, about 45 at% or more, about 45 at% or less, about 50 at% or less, about 55 at% or less, or about 60 at% or less. The content of the carbon element may be less than or equal to the content of the nitrogen element. For example, the content of the carbon element may be greater than 0 at%, greater than or equal to about 1 at%, greater than or equal to about 2 at%, greater than or equal to about 3 at%, greater than or equal to about 4 at%, less than or equal to about 5 at%, less than or equal to about 6 at%, less than or equal to about 7 at%, less than or equal to about 8 at%, less than or equal to about 9 at%, or less than or equal to about 10 at%.

In some example embodiments, the charge storage particles 122 may include MO (M being metal) or MAO (M being metal). Here, the M may include at least one of Hf, Ti, Zr, U, Th, Cr, Ga, V, Sc, Lu, Yb, Er, Ho, Dy, Gd, Eu, Sm, Y, Nd, Ce, La, Ni, Mg, Cu, Zn, Co, Fe, Mn, Ca, Eu, Sr, Sm, Cu, Ru, Pt, Mo, W, Co, or Pd. A may include at least one of Si or Al. The charge storage particles 122 may include, for example, HfO or HfSiO.

In some example embodiments, the charge storage particles 122 may include metal or semiconductor. The metal includes, for example, at least one of Hf, Ti, Zr, U, Th, Cr, Ga, V, Sc, Lu, Yb, Er, Ho, Dy, Gd, Eu, Sm, Y, Nd, Ce, La, Ni, Mg, Cu, Zn, Co, Fe, Mn, Ca, Eu, Sr, Sm, Al, Cu, Ru, Pt, Mo, W, Co, or Pd, and the semiconductor may include at least one of Si or Ge.

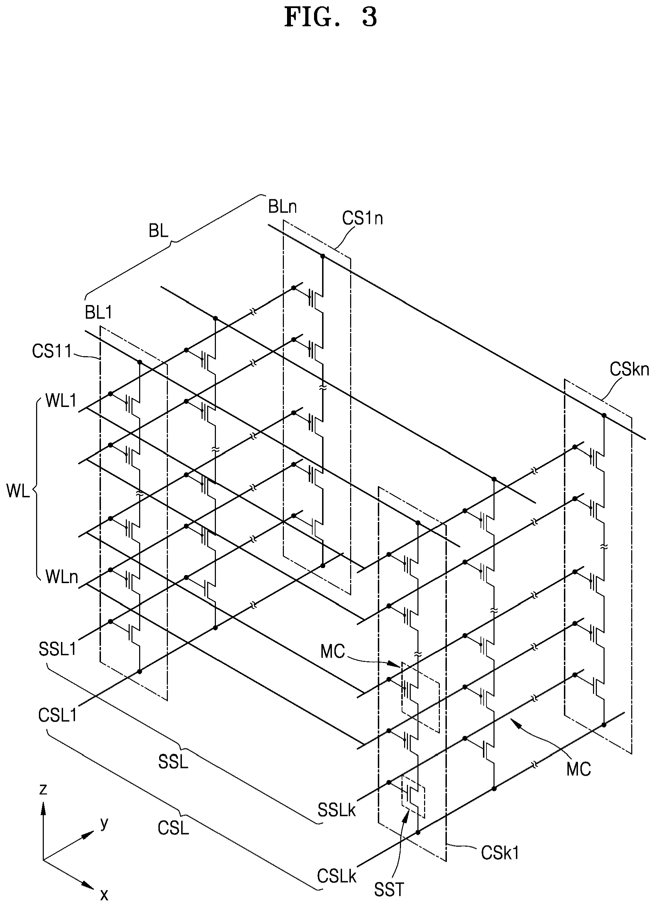

FIG. 3 illustrates a circuit diagram including the nonvolatile memory device 100 of FIG. 1 according to an example embodiment. k*n cell strings CS may be provided and arranged in a matrix form, and may be referred to as CSij (1≤i≤k, 1≤j≤n) according to respective row and column positions. Each cell string CSij may be connected to a bit line BL, a string selection line SSL, word lines WL, and a common source line CSL.

Each cell string CSij includes memory cells MC and a string selection transistor SST. The memory cells MC and the string selection transistors SST of each cell string CSij may be stacked in a height direction.

The rows of the plurality of cell strings CS are connected to different string selection lines SSL1 to SSLk, respectively. For example, string selection transistors SST of the cell strings CS11 to CS1n are commonly connected to a string selection line SSL1. The string selection transistors SST of the cell strings CSk1 to CSkn are connected in common to a string selection line SSLk.

The columns of the plurality of cell strings CS are connected to different bit lines BL1 to BLn, respectively. For example, the memory cells MC of the cell strings CS11 to CSk1 and the string selection transistors SST may be connected in common to the bit line BL1, and the memory cells MC of the cell strings CS1n to CSkn and the string selection transistors SST may be connected in common to the bit line BLn.

The rows of the plurality of cell strings CS may be connected to different common source lines CSL1 to CSLk, respectively. For example, the string selection transistors SST of the cell strings CS11 to CS1n may be connected in common to the common source line CSL1, and the string selection transistors SST of the cell strings CSk1 to CSkn may be connected in common to the common source line CSLk.

Memory cells MC positioned at the same height from the string selection transistors SST may be connected in common to one word line WL, and memory cells MC positioned at different heights may be connected to different word lines WL1 to WLn, respectively.

The circuit structure shown is illustrative. For example, the number of rows of the cell strings CS may be increased or decreased. As the number of rows of the cell string CS changes, the number of string selection lines connected to the rows of the cell string CS and the number of cell strings CS connected to one bit line BL may also change. As the number of rows of cell strings CS changes, the number of common source lines connected to the rows of cell strings CS may also change.

The number of columns of the cell strings CS may be increased or decreased. As the number of columns of the cell string CS changes, the number of bit lines BLs connected to the columns of the cell strings CS and the number of cell strings CS connected to one string selection line may also change.

The height of the cell string CS may also be increased or decreased. For example, the number of memory cells MC stacked in each of the cell strings CS may be increased or decreased. As the number of memory cells MC stacked in each of the cell strings CS changes, the number of word lines WL may also change. For example, the number of string selection transistors provided to each of the cell strings CS may be increased. As the number of string selection transistors provided to each of the cell strings CS changes, the number of string selection lines or common source lines may also change. When the number of string selection transistors SST increases, the string selection transistors SST may be stacked in the same form as the memory cells MC.

For example, write and read may be performed in units of rows of the cell strings CS. The cell strings CS may be selected in units of one row by the common source line CSL, and the cell strings CS may be selected in units of one row by the string selection lines SSL. A voltage may be applied to the common source lines CSL in units of at least two common source lines CSL. In some example embodiments, a voltage may be applied to the common source lines CSL in a single unit throughout the common source lines CSL.

In a selected row of the cell strings CS, write and read may be performed in units of pages. The page may be one row of memory cells coupled to one word line WL. In a selected row of cell strings CS, memory cells may be selected in units of pages by word lines WL. For example, each gate electrode 131 of FIG. 1 may be connected to one of the word line WL or the string selection line SSL.

Each of the memory cells MC has a circuit structure in which a transistor including a gate electrode 131, a plurality of separators 132, and a channel layer 124 and charge storage particles 122 are connected or are present.

The memory cells MC are continuously arranged in the vertical direction (Z-axis direction) to form a cell string CS. In addition, both ends of a cell string CS may be connected to a common source line CSL and a bit line BL, respectively, as shown in the circuit diagram of FIG. 3. Programming, reading, and erasing processes may be performed on a plurality of memory cells MC by applying voltages to the common source line CSL and the bit line BL.

For example, when a memory cell MC to write is selected, the gate voltage value of the memory cell is adjusted so that no channel is formed in the selected memory cell, (e.g., to be in a channel-off state), and the gate voltage value of the memory cells that are not selected is adjusted to be in a channel-on state. Accordingly, charges may be stored in the charge storage particles 122 of the selected memory cell MC by tunneling the charge tunneling layer 123 by voltages applied to the common source line CSL and the bit line BL, thereby recording information of desired 1 or 0 in the selected memory cell MC.

Similarly, in a read operation, a read operation on a selected cell may be performed. That is, after the gate voltage applied to each gate electrode 131 is adjusted so that the selected memory cell MC is in a channel-off state and the unselected memory cells are in a channel-on state, the memory cell state 1 or 0 may be confirmed by measuring the current flowing through the corresponding memory cell MC by the applied voltage Vread between the common source line CSL and the bit line BL.

The nonvolatile memory device 100 has a structure in which cells are connected to each other in the vertical direction. When information is stored, charges are diffused in the vertical direction and move to an adjacent cell, thereby affecting the operation of the adjacent cell.

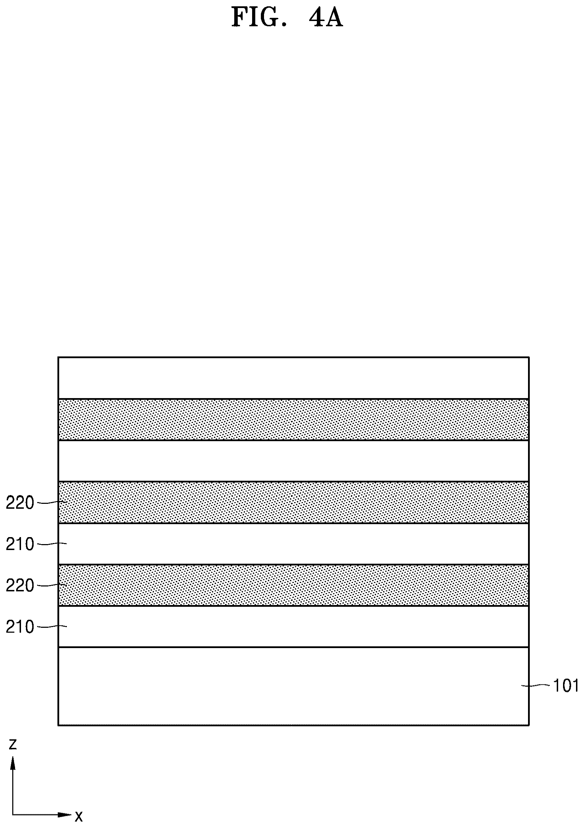

FIGS. 4A to 4H are reference views illustrating a method of manufacturing a nonvolatile memory device 100 according to an example embodiment.

As illustrated in FIG. 4A, first insulating material layers 210 and second insulating material layers 220 may be alternately stacked on a substrate 101. The first insulating material layers 210 and the second insulating material layers 220 may be alternately stacked in a direction perpendicular to the surface of the substrate 101. The first and second insulating material layers 210 and 220 may be formed of or include different materials, respectively. The first and second insulating material layers 210 and 220 may include, for example, silicon oxide, silicon nitride, etc., but example embodiments are not limited thereto.

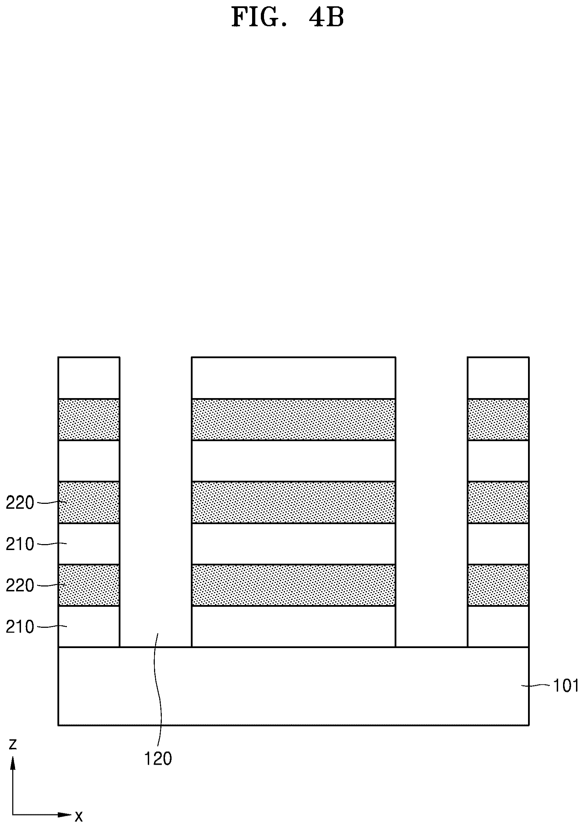

As illustrated in FIG. 4B, channel holes 120 are formed to penetrate the first and second insulating material layers 210 and 220. Here, the channel holes 120 may be formed to extend in a direction perpendicular to the surface of the substrate 101. The channel holes 120 may be formed to have a circular cross-section. The channel holes 120 may be formed by anisotropically etching the first insulating material layer 210 and the second insulating material layer 220. The surface of the substrate 101 may be exposed by the channel holes 120.

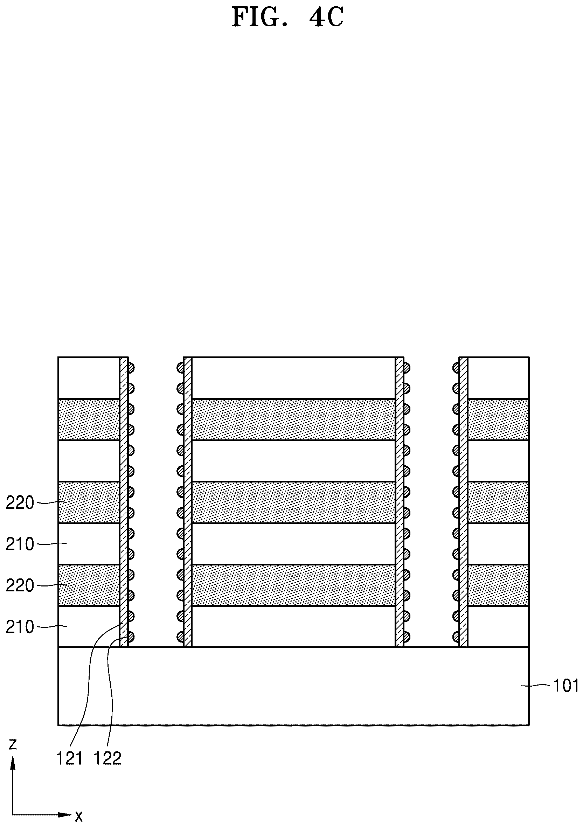

As shown in FIG. 4C, a charge blocking layer 121 and a plurality of charge storage particles 122 may be sequentially formed on an inner wall (e.g., an inner boundary or an inner side boundary) of each of the channel holes 120. The charge blocking layer 121 may extend in a direction perpendicular to the surface of the substrate 101. The charge blocking layer 121 may be formed on an inner wall (e.g., an inner boundary or an inner side boundary) of each of the channel holes 120 to be in contact with the first and second insulating material layers 210 and 220. Each of the plurality of charge storage particles 122 may be formed to be in contact with an inner side surface of the charge blocking layer 121. The plurality of charge storage particles 122 may be spaced apart from each other.

After forming a charge storage material layer on the charge blocking layer 121, a heat treatment process may be performed to form the plurality of charge storage particles 122. The heat treatment process may be performed at a temperature of about 400 °C to about 1,200 °C. In some example embodiments, the plurality of charge storage particles 122 may be formed by surface tension after a charge storage material is formed on the charge blocking layer 121.

The charge storage material layer may include a material having a relatively high dielectric constant and/or a relatively high storage density. The charge storage particles 122 may include a quaternary or higher material. For example, the charge storage particles 122 may include a matrix material with a relatively high storage density and a crystallization control material that controls the crystallization of the matrix material. The content of the matrix material in the charge storage material layer may be dominant at least about 80 at%, at least about 85 at%, at least about 90 at%, or at least about 95 at%. In the charge storage particles 122, the content of the crystallization control material may be about 20 at% or less, about 15 at% or less, about 10 at% or less, or about 5 at% or less.

The matrix material may include oxynitride. For example, the matrix material may include at least one of aluminum oxynitride or silicon oxynitride. The matrix material includes nitrides, as well as oxides, which may implement relatively low formation energy and relatively deep trap charge states while having intrinsic defects caused by nitrogen vacancies.

The crystallization control material may include at least one of hafnium nitride, aluminum nitride, boron nitride, gallium nitride, silicon oxide, aluminum oxide, magnesium oxide, zirconium carbide, hafnium carbide, silicon carbide, silicon carbide, silicon carbide, or aluminum carbide.

In some example embodiments, the charge storage material layer may include MO (M is metal) or MAO (M is metal). Here, the M may include at least one of Hf, Ti, Zr, U, Th, Cr, Ga, V, Sc, Lu, Yb, Er, Ho, Dy, Gd, Eu, Sm, Y, Nd, Ce, La, Ni, Mg, Cu, Zn, Co, Fe, Mn, Ca, Eu, Sr, Sm, or Cu. A may include at least one of Si, B, or Al. The charge storage particles 122 may include, for example, HfO or HfSiO.

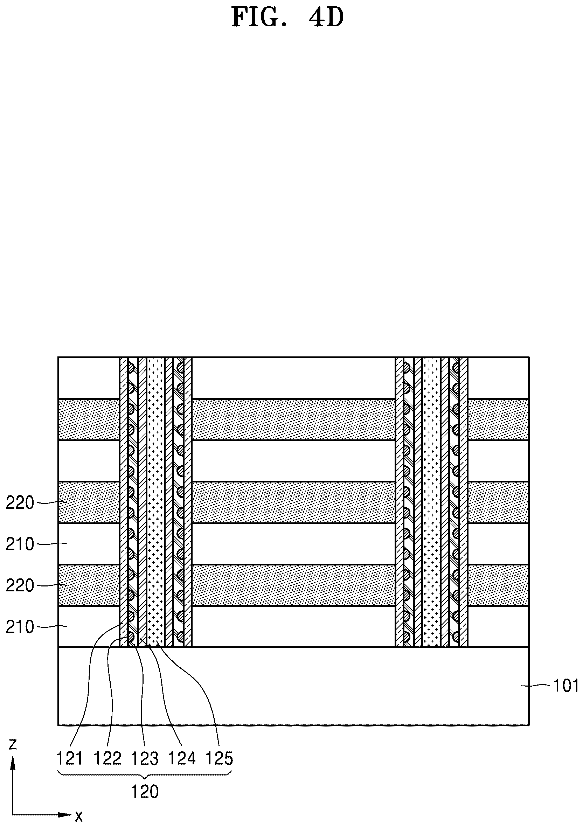

As illustrated in FIG. 4D, a charge tunneling layer 123 covering the plurality of charge storage particles 122 may be formed on the inner wall of the charge blocking layer 121, and a channel layer 124 and a pillar 125 may be sequentially formed on the inner wall of the charge tunneling layer 123.

The charge tunneling layer 123 may be in contact with the charge blocking layer 121 while covering the charge storage particles 122. In addition, the channel layer 124 may be formed to contact the inner side surface of the charge tunneling layer 123, and a pillar 125 may be further formed in the channel layer 124. Although the pillar 125 is formed in FIG. 4D, example embodiments are not limited thereto. The pillars 125 may be formed together when forming gate electrodes 131 to be described later.

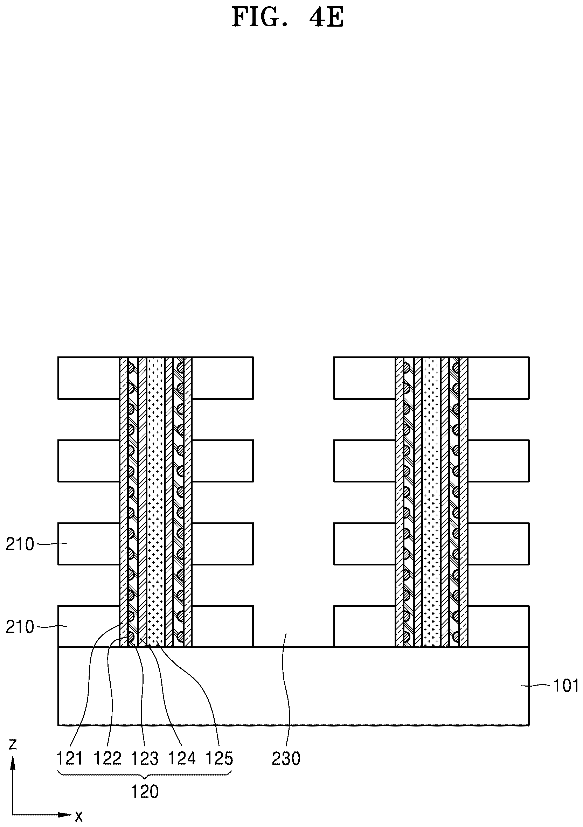

As shown in FIG. 4E, an opening 230 penetrating the first and second insulating material layers 210 and 220 may be formed, and the second insulating material layers 220 may be removed to expose the gate insulating layer 121. The second insulating material layers 220 may be etched by a wet etching process.

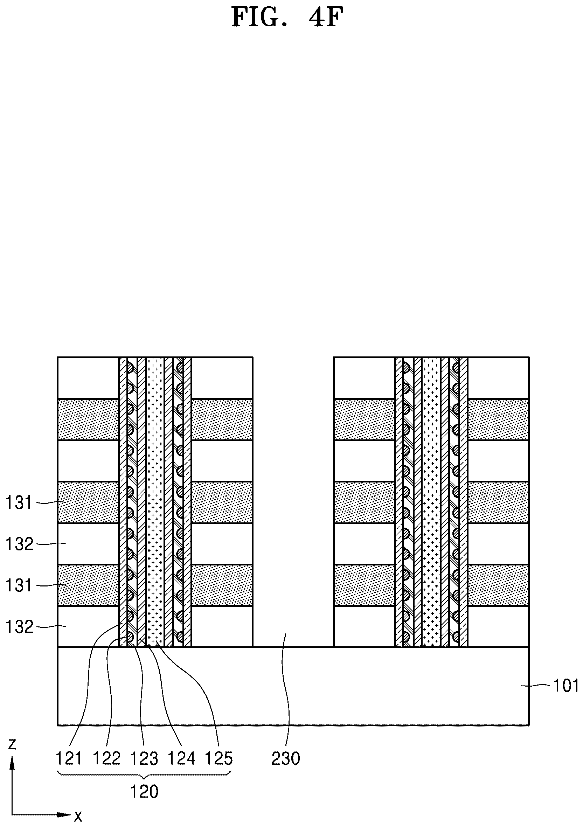

As illustrated in FIG. 4F, gate electrodes 131 may be formed in regions from which the second insulating material layers 220 are removed. According to some example embodiments, when the gate electrodes 131 are formed, the pillar 125 may also be formed. The remaining first insulating material layers 210 may be separators 132.

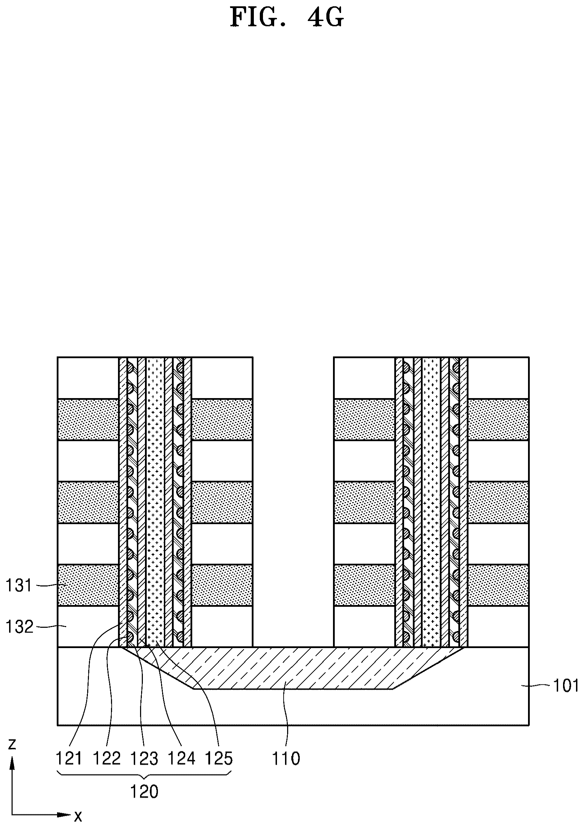

As illustrated in FIG. 4G, a common source region 110 may be formed on the substrate 101 exposed by the opening 230. The common source region 110 may be formed by doping n-type impurities, such as phosphorus (P).

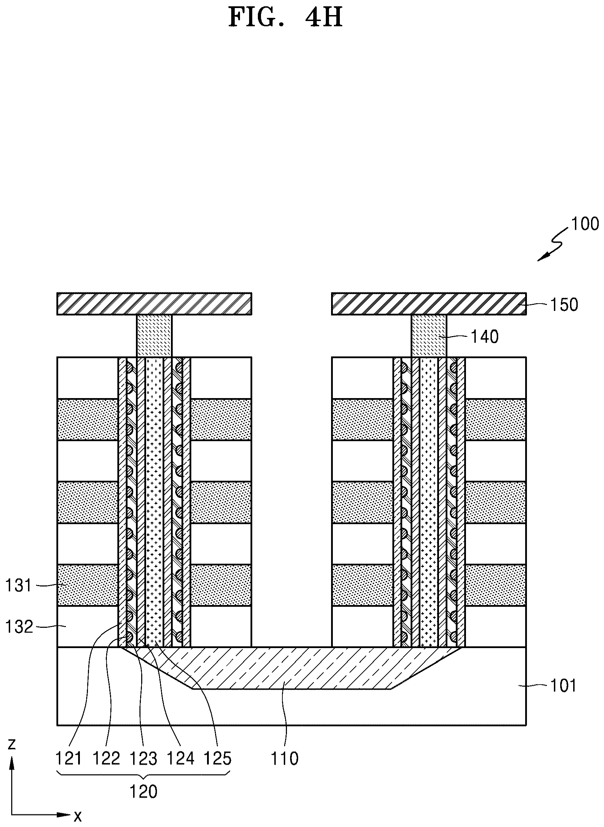

As shown in FIG. 4H, a drain 140 may be formed on the channel layer 124, and a bit line 150 may be formed on the drain 140.

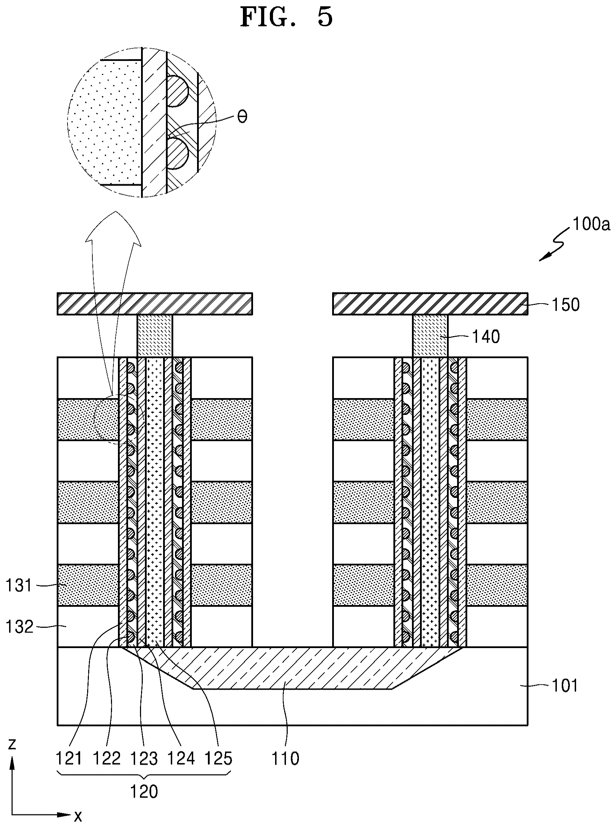

FIG. 5 is a cross-sectional view illustrating a schematic structure of a nonvolatile memory device 100a according to another example embodiment. Comparing FIGS. 1 and 5 with each other, each of the charge storage particles 122 included in the nonvolatile memory device 100a of FIG. 5 may have an acute angle θ between the charge blocking layer 121 and the outer circumferential surface of each of the charge storage particles 122. For example, an angle θ between the charge blocking layer 121 and the outer circumferential surface of each of the charge storage particles 122 may be about 30 degrees or greater to less than about 90 degrees. Because the charge storage particles 122 have a truncated spherical shape larger than a hemi-sphere, the volume of each of the charge storage particles 122 shown in FIG. 5 is larger than the volume of each of the charge storage particles 122 shown in FIG. 1. The charge storage particles 122 may store charges more stably. In addition, the charge storage particles 122 of FIG. 5 have no points in the vertical direction (Z-axis direction) with respect to the surface of the substrate 101, and thus, the side charge loss may be further reduced.

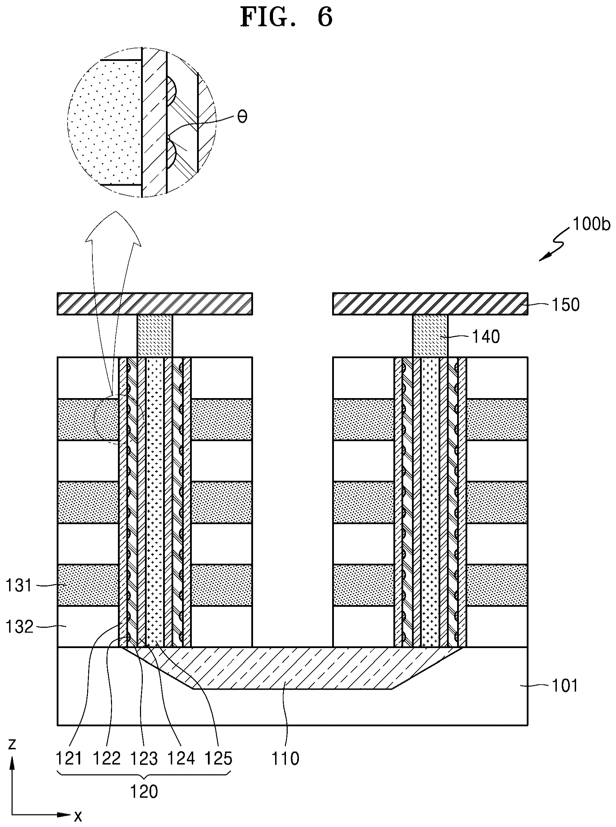

FIG. 6 is a cross-sectional view illustrating a schematic structure of a nonvolatile memory device 100b according to another example embodiment. Comparing FIGS. 1 and 6 with each other, each of the charge storage particles 122 included in the nonvolatile memory device 100b of FIG. 6 may have an obtuse angle θ between the charge blocking layer 121 and the outer circumferential surface of each of the charge storage particles 122. For example, an angle θ between the charge blocking layer 121 and the outer circumferential surface of each of the charge storage particles 122 may be more than about 90 degrees to about 150 degrees or less. Each of the charge storage particles 122 may have a truncated spherical shape smaller than a hemi-sphere. A radius of curvature of each of the charge storage particles 122 shown in FIG. 6 with respect to the second curved surface S2 may be greater than a radius of curvature of each of the charge storage particles 122 shown in FIG. 1 with respect to the second curved surface S2. An increase in surface roughness of the channel layer 124 due to the curvature of the charge storage particles 122 may be reduced. An angle θ between the charge blocking layer 121 and the outer circumferential surface of each of the charge storage particles 122 may be determined according to the use of the nonvolatile memory device 100b.

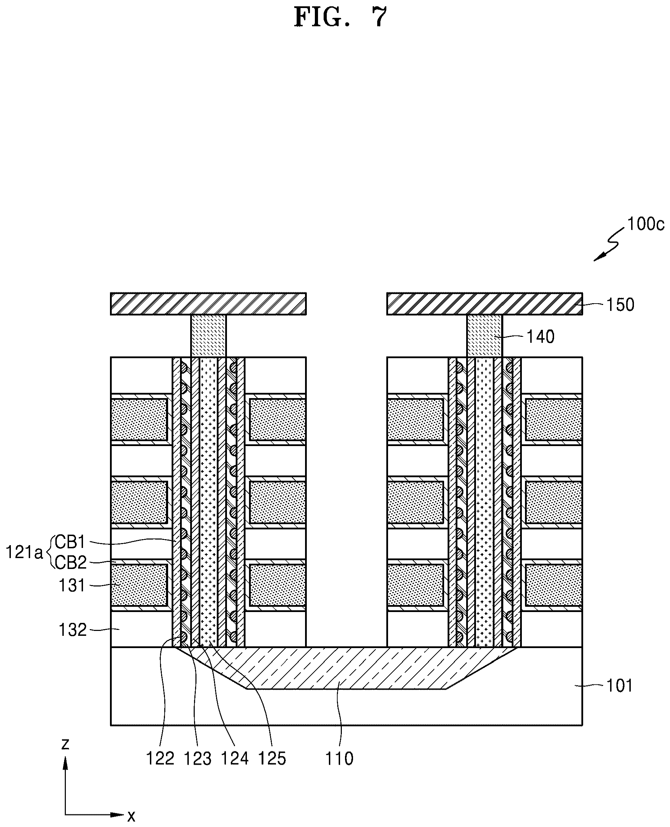

FIG. 7 is a cross-sectional view illustrating a nonvolatile memory device 100c including a double charge blocking layer 121a according to an example embodiment. Comparing FIGS. 1 and 7 with each other, a charge blocking layer 121a included in the nonvolatile memory device 100c of FIG. 7 may include a first charge blocking layer CB1 arranged at the outermost portion of the channel hole 120, and a second charge blocking layer CB2 arranged between the gate electrode 131 and the separator 132 and between the gate electrode 131 and the first charge blocking layer CB1. The first charge blocking layer CB1 has the same configuration and operation effect as the charge blocking layer 121 shown in FIG. 1, and thus a detailed description thereof is omitted.

The second charge blocking layer CB2 may be provided between the gate electrode 131 and the separator 132, and between the gate electrode 131 and the first charge blocking layer CB1. However, example embodiments are not limited thereto, and the second charge blocking layer CB2 may be provided only between the gate electrode 131 and the first charge blocking layer CB1. In some example embodiments, the positions of the first charge blocking layer CB1 and the second charge blocking layer CB2 may be reversed. In some other example embodiments, the first charge blocking layer CB1 may have a shape surrounding the second charge blocking layer CB2.

The second charge blocking layer CB2 may include a ferroelectric material or an anti-ferroelectric material. A ferroelectric material is a material having ferroelectricity that maintains spontaneous polarization by aligning internal electrical dipole moments even when an electric field is not applied from the outside. Ferroelectric materials exhibit spontaneous polarization with permanent dipoles arranged in parallel in the same direction. The ferroelectric material may have remnant polarization by dipoles even in the absence of an external electric field. In addition, the direction of the polarization may be switched in units of domains by an external electric field.

The anti-ferroelectric material may include an array of electrical dipoles, but may have a remnant polarization of zero or close to zero. Because the directions of adjacent dipoles are reversed in the absence of an electric field, the overall spontaneous polarization and remnant polarization may be zero or close to zero. However, when an external electric field is applied, polarization characteristics and switching characteristics may be exhibited.

The ferroelectric material may include a hafnium oxide material or an aluminum nitride material. The ferroelectric material may have a structure in which a dopant is inserted into a hafnium oxide-based material or a structure in which a dopant is inserted into an aluminum nitride-based material. When the ferroelectric material is a hafnium oxide-based material, the dopant may be Zr, La, Al, Si, or Y. When the ferroelectric material is an aluminum nitride-based material, the dopant may be B or Sc.

In some example embodiments, the ferroelectric material may include, for example, a ferroelectric material having at least one of a fluorite structure, a perovskite structure, or a wurtzite structure.

The ferroelectric material having a fluorite structure may include, for example, HfO₂ or ZrO₂. Here, HfO₂ or ZrO₂ may have a crystal structure of a tetragonal system or a crystal structure of an orthorhombic system. The crystal structure of the tetragonal system may have anti-ferroelectricity, and the crystal structure of the orthorhombic system may have ferroelectricity. The undoped HfO₂ has a stable crystal structure of a tetragonal system, but may also have a crystal structure of an orthorhombic system depending on the grain size. The undoped ZrO₂ may have a stable crystal structure of a tetragonal system. Undoped HfO₂ or ZrO₂ may include, for example, nanocrystals having a grain size of about 1 nm to about 3 nm, but example embodiments are not limited thereto.

The fluorite-based material may include, for example, HfO₂ or ZrO₂ including a dopant. Here, the dopant may include at least one of Al, Ga, Co, Ni, Mg, In, La, Y, Nd, Sm, Er, Sr, Ba, Gd. Ge, N, or Si. However, this is merely illustrative. HfO₂ or ZrO₂ including the dopant may have a tetragonal system crystal structure having anti-ferroelectricity or an orthorhombic system crystal structure having ferroelectricity according to the grain size and doping concentration. The smaller the grain size and the higher the doping concentration, the more stable the tetragonal system crystal structure, and the larger the grain size and the lower the doping concentration, the more stable the orthorhombic system crystal structure.

HfO₂ or ZrO₂ doped with dopants may include nanocrystals having a larger grain size than the undoped HfO₂ or ZrO₂ described above. For example, HfO₂ or ZrO₂ doped with dopants may have a grain size of approximately 4 nm to 7 nm, or approximately 4 nm to 5 nm, but example embodiments are not limited thereto.

The concentration of the dopant may be variously changed according to the type of the dopant. For example, when the dopant is Si, the doping concentration may be about 1 at% (atomic percent) to about 5 at%. However, example embodiments are not limited thereto.

The ferroelectric material having a perovskite structure may include a material having a composition of M1M2O₃ (M1 and M2 are metal elements). The perovskite-based material may include at least one of, for example, PbZrO₃, PbTiO₃, BaTiO₃, SrTiO₃, or CaTiO₃. However, example embodiments are not limited thereto. The perovskite-based material may have a tetragonal system crystal structure having anti-ferroelectricity or an orthorhombic system crystal structure having ferroelectricity according to the composition ratio of constituent elements.

The wurtzite-based material may include undoped AIN, GaN, or InN, or may include AIN, GaN, or InN including dopants. The dopant may include at least one of boron (B) or scandium (Sc).

For example, the second charge blocking layer 240 may include hafnium zirconium oxide (HfZrO), and Zr/(Hf+Zr) may be in a range of about 20 at% to about 80 at%.

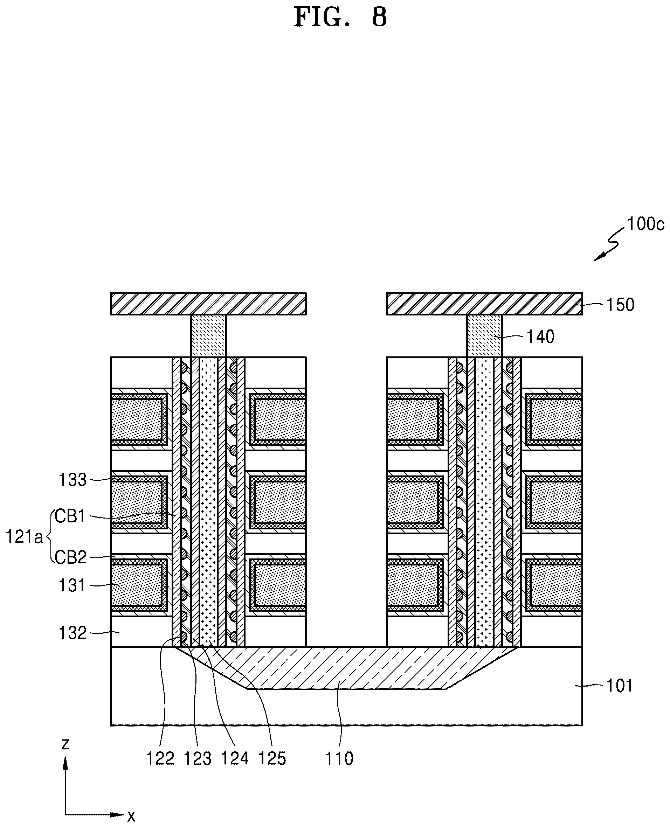

FIG. 8 is a cross-sectional view illustrating a nonvolatile memory device 100d further including a diffusion barrier layer 133 according to an example embodiment. Comparing FIG. 7 with FIG. 8, the nonvolatile memory device 100d of FIG. 8 may further include a diffusion barrier layer 133 between the gate electrode 131 and the second charge blocking layer CB2. The diffusion barrier layer 133 may reduce or prevent reaction and diffusion between the gate electrode 131 and the separator or between the gate electrode 131 and the charge storage particles 122. The diffusion barrier layer 133 may include a material having an oxidation-reduction potential greater than that of the separator 132. The diffusion barrier layer 133 may include at least one of titanium (Ti), zirconium (Zr), vanadium (V), aluminum (Al), lanthanum (La), niobium (Nb), tantalum (Ta), or nitride including at least one of them. The diffusion barrier layer 133 may include, for example, TiN or NbN.

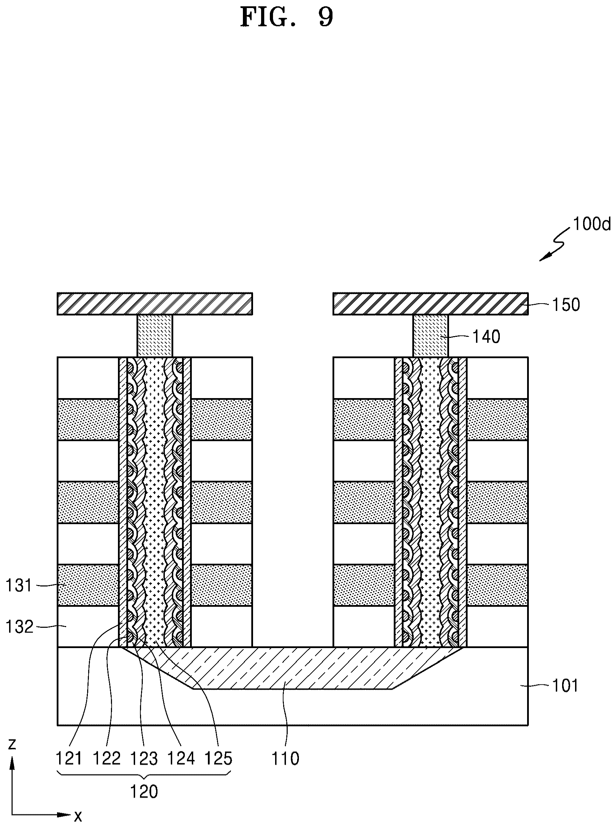

FIG. 9 is a cross-sectional view illustrating a nonvolatile memory device 100e including a curved charge blocking layer 123 and a channel layer 124 according to an example embodiment. Comparing FIGS. 1 and 9 with each other, the nonvolatile memory device 100e of FIG. 9 may include the charge tunneling layer 123 whose side surface is curved corresponding to the plurality of charge storage particles 122. A side surface of the channel layer 124 may also be curved corresponding to the plurality of charge storage particles 122.

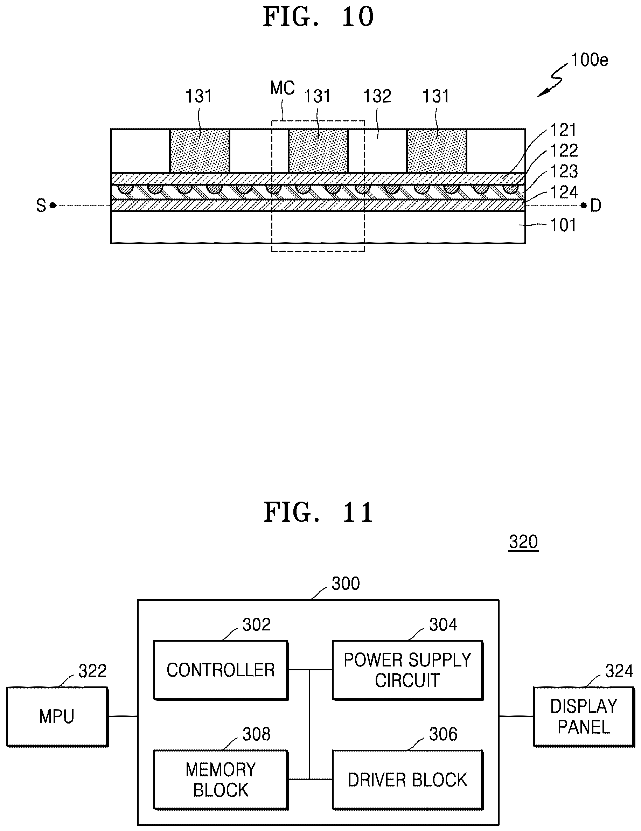

FIG. 10 is a cross-sectional view illustrating a nonvolatile memory device 100f according to an example embodiment. Comparing FIG. 1 with FIG. 10, in the nonvolatile memory device 100e of FIG. 10, a channel layer 124 may be arranged to be parallel to the surface of the substrate 101. A charge tunneling layer 123 may be arranged on the channel layer 124, and a charge blocking layer 121 may be arranged on the charge tunneling layer 123. In addition, a plurality of gate electrodes 131 may be arranged on the charge blocking layer 121. A plurality of separators 132 for separating the adjacent gate electrodes 131 may be further arranged in the spaces between the plurality of gate electrodes 131.

A plurality of charge storage particles 122 spaced apart from each other may be arranged between the charge tunneling layer 123 and the charge blocking layer 121. The gaps between the gate electrodes 131 corresponding to the plurality of charge storage particles 122 may be constant, and the gap between the channel layer 124 and at least one of the plurality of charge storage particles 122 may not be constant. For example, the gap d2 between at least one of the plurality of charge storage particles 122 and the channel layer 124 may gradually decrease from the edge area of each of the charge storage particles 122 to the center area of each of the charge storage particles.

In some example embodiments, the first surface of each of the charge storage particles 122 may be arranged in the charge blocking layer 121, the second surface thereof may be arranged in the charge tunneling layer 123, and the radius of curvature of the second surface may be less than the radius of curvature of the first surface. An angle between the charge blocking layer 121 and the outer circumferential surface of at least one of the plurality of charge storage particles 122 may be about 30 degrees to about 150 degrees. For example, at least one of the plurality of charge storage particles 122 may have a shape of a truncated sphere.

A length of each of the plurality of charge storage particles 122 may be less than a thickness of each of the gate electrodes 131 in a direction parallel to a surface of the charge blocking layer 121. For example, a length of each of the plurality of charge storage particles 122 may be about 1/2 or less than a thickness of each of the gate electrodes 131 in a direction parallel to a surface of the charge blocking layer 121.

A source electrode S and a drain electrode D may be connected to both ends of the channel layer 124, respectively. The nonvolatile memory device 100c of FIG. 10 may be referred to as a horizontal nonvolatile memory device 100c. Although not shown in the drawings, the charge blocking layer 121 may have a multi-layered structure and may further include a diffusion prevention layer.

The nonvolatile memory device maintains information even when power supply thereto is interrupted, and thus includes a plurality of memory cells capable of using stored information again when power is supplied thereto. The nonvolatile memory device may be widely applied to mobile phones, digital cameras, personal digital assistants (PDA), mobile computer devices, and the like.

FIG. 11 is a schematic block diagram of a display driver integrated circuit (IC) (DDI) 300 and a display device 320 including the DDI according to an example embodiment. Referring to FIG. 11, the DDI 300 may include a controller 302, a power supply circuit 304, a driver block 306, and a memory block 308. The controller 302 receives and decodes a command applied from a main processing unit (MPU) 322, and controls each block of the DDI 300 to implement an operation according to the command. The power supply circuit 304 generates a driving voltage in response to the control by the controller 302. The driver block 306 drives a display panel 324 using the driving voltage generated by the power supply circuit 304 in response to the control by the controller 302. For example, the display panel 324 may be a liquid crystal display panel, an organic light-emitting device (OLED) display panel, or a plasma display panel. The memory block 308 is a block that temporarily stores a command input to the controller 302 or control signals output from the controller 302, or stores necessary or desired data, and may include a memory such as random access memory (RAM) and read only memory (ROM). For example, the memory block 308 may include the nonvolatile memory devices 100, 100a, 100b, 100c, 100d, 100e, and 100f according to the example embodiments described above.

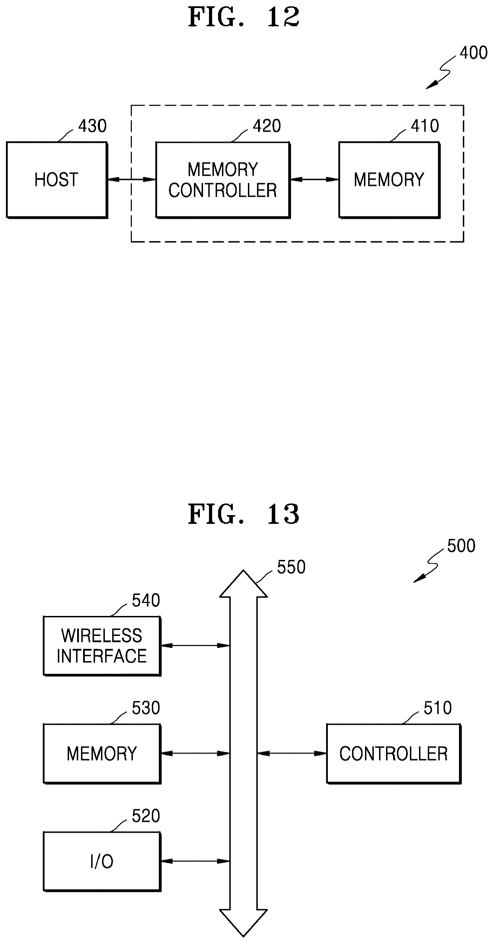

FIG. 12 is a block diagram illustrating an electronic device 400 according to an example embodiment. Referring to FIG. 12, an electronic device 400 includes a memory 410 and a memory controller 420. The memory controller 420 may control the memory 410 to read data from the memory 410 and/or write data to the memory 410 in response to a request from a host 430. The memory 410 may include the nonvolatile memory devices 100, 100a, 100b, 100c, 100d, 100e, and 100f according to the example embodiments described above.

FIG. 13 is a block diagram illustrating an electronic device 500 according to an example embodiment. Referring to FIG. 13, the electronic device 500 may configure a wireless communication device or a device capable of transmitting and/or receiving information in a wireless environment. The electronic device 500 includes a controller 510, an input/output (I/O) device 520, a memory 530, and a wireless interface 540, each of which is interconnected through a bus 550.

The controller 510 may include at least one of a microprocessor, a digital signal processor, or a processing device similar thereto. The I/O device 520 may include at least one of a keypad, a keyboard, or a display. The memory 530 may be used to store commands executed by the controller 510. For example, the memory 530 may be used to store user data. The electronic device 500 may use the wireless interface 540 to transmit/receive data through a wireless communication network. The wireless interface 540 may include an antenna and/or a wireless transceiver. In some configurations, the electronic device 500 may be used in communication interface protocols of third-generation communication systems, such as code division multiple access (CDMA), global system for mobile communications (GSM), north American digital cellular (NADC), extended-time division multiple access (E-TDMA), and/or wide band code division multiple access (WCDMA). The memory 530 in the electronic device 500 may include the nonvolatile memory devices 100, 100a, 100b, 100c, 100d, 100e, and 100f according to the example embodiments described above.

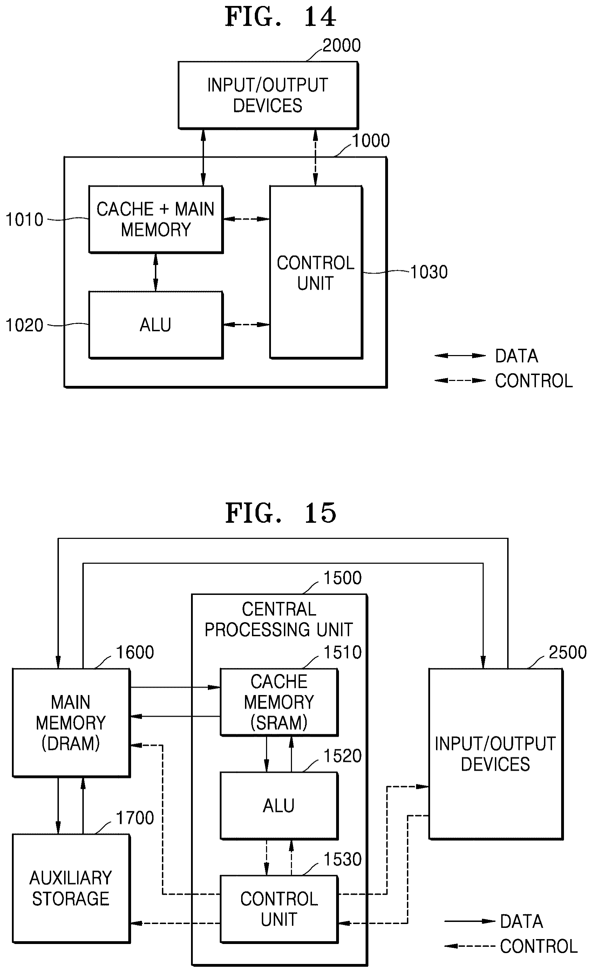

FIGS. 14 and 15 are conceptual diagrams schematically illustrating device architectures applicable to electronic devices according to some example embodiments, respectively.

Referring to FIG. 14, an electronic device architecture 1000 may include a memory unit 1010 and a control unit 1030, and may further include an arithmetic logic unit (ALU) 1020. The memory unit 1010, the ALU 1020, and the control unit 1030 may be electrically connected to each other. For example, the electronic device architecture 1000 may be implemented as a single chip including the memory unit 1010, the ALU 1020, and the control unit 1030. In some example embodiments, the memory unit 1010, the ALU 1020, and the control unit 1030 may be interconnected in an on-chip via a metal line to communicate directly with each other. The memory unit 1010, the ALU 1020, and the control unit 1030 may be monolithically integrated on one substrate 101 (see FIG. 4A) to form one chip. Input/output devices 2000 may be connected to the electronic device architecture (chip) 1000. In addition, the memory unit 1010 may include both a main memory and a cache memory. The electronic device architecture (chip) 1000 may be an on-chip memory processing unit. The memory unit 1010, the ALU 1020, and/or the control unit 1030 may each independently include the nonvolatile memory devices 100, 100a, 100b, 100c, 100d, 100e, and 100f according to the example embodiments described above.

Referring to FIG. 15, a cache memory 1510, an ALU 1520, and a control unit 1530 may constitute a central processing unit (CPU) 1500, and the cache memory 1510 may include static random access memory (SRAM). Apart from the CPU 1500, a main memory 1600 and an auxiliary storage 1700 may be provided, and input/output devices 2500 may be provided. The main memory 1600 may be, for example, dynamic random access memory (DRAM), and may include the nonvolatile memory devices 100, 100a, 100b, 100c, 100d, 100e, and 100f according to the example embodiments described above.

In some cases, an electronic device architecture may be implemented in a form in which computing unit devices and memory unit devices are adjacent to each other in one chip without distinction of sub-units.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that the example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A nonvolatile memory device comprising:
a substrate;
a plurality of separators and a plurality of gate electrodes alternately stacked in a first direction perpendicular to a surface of the substrate, the plurality of separators and the plurality of gate electrodes including a channel hole passing therethrough in the first direction;
a charge blocking layer inside the channel hole;
a plurality of charge storage particles inside the charge blocking layer and each having an asymmetric shape with respect to the first direction;
a charge tunneling layer inside the charge blocking layer and covering the plurality of charge storage particles; and
a channel layer inside the charge tunneling layer.

2. The nonvolatile memory device of claim 1, wherein each of the plurality of charge storage particles is in contact with the charge blocking layer and is spaced apart from the channel layer.

3. The nonvolatile memory device of claim 1 or 2, wherein a first gap between the plurality of charge storage particles and the plurality of gate electrodes is constant, and a second gap between the channel layer and at least one of the plurality of charge storage particles is not constant, and optionally wherein the second gap between the channel layer and the at least one of the plurality of charge storage particles gradually decreases and then gradually increases from a lower end of the at least one of the plurality of charge storage particles to an upper end of the at least one of the plurality of charge storage particles.

4. The nonvolatile memory device of any preceding claim, wherein
at least one of the plurality of charge storage particles includes a first curved surface facing the charge blocking layer and a second curved surface facing the channel layer, and
a first radius of curvature of the first curved surface is different from a second radius of curvature of the second curved surface, and optionally wherein the second radius of curvature of the second curved surface is smaller than the first radius of curvature of the first curved surface.

5. The nonvolatile memory device of any preceding claim, wherein at least one of the plurality of charge storage particles has a shape of a truncated sphere.

6. The nonvolatile memory device of any preceding claim, wherein a length of each of the plurality of charge storage particles in the first direction is less than a thickness of each of the plurality of gate electrodes in the first direction.

7. The nonvolatile memory device of any preceding claim, wherein the plurality of charge storage particles are arranged to be spaced apart from each other in the first direction.

8. The nonvolatile memory device of any preceding claim, wherein an angle between the charge blocking layer and an outer circumferential surface of at least one of the plurality of charge storage particles is in a range between 30 degrees and 150 degrees.

9. The nonvolatile memory device of any preceding claim, wherein an inner side surface of the charge tunneling layer has a curved shape corresponding to the plurality of charge storage particles.

10. The nonvolatile memory device of any preceding claim, wherein an inner side surface of the channel layer has a curved shape corresponding to the plurality of charge storage particles.

11. The nonvolatile memory device of any preceding claim, wherein at least one of the plurality of charge storage particles comprises at least one of semiconductor, metal, MO (M is metal), or MAO (M is metal), where A includes at least one of Si or Al, and optionally wherein the M includes at least one of Hf, Ti, Zr, U, Th, Cr, Ga, V, Sc, Lu, Yb, Er, Ho, Dy, Gd, Eu, Sm, Y, Nd, Ce, La, Ni, Mg, Cu, Zn, Co, Fe, Mn, Ca, Eu, Sr, Sm, or Cu, Ru, Pt, Mo, W, Co, or Pd.

12. A method of manufacturing a nonvolatile memory device, the method comprising:
alternately forming a plurality of first insulating material layers and a plurality of second insulating material layers on a substrate;
forming a channel hole penetrating the plurality of first insulating material layers and the plurality of second insulating material layers in a first direction perpendicular to the substrate;
forming a charge blocking layer inside the channel hole;
forming a plurality of charge storage particles having an asymmetric shape in the first direction inside the charge blocking layer;
forming a charge tunneling layer covering the plurality of charge storage particles inside the charge blocking layer; and
forming a channel layer inside the charge tunneling layer.

13. The method of claim 12, further comprising:
replacing the plurality of second insulating material layers with a plurality of gate electrodes, respectively,
wherein a first gap between the plurality of charge storage particles and the plurality of gate electrodes is constant, and a second gap between the channel layer and at least one of the plurality of charge storage particles is not constant, and optionally wherein the second gap between the channel layer and the at least one of the plurality of charge storage particles gradually decreases and then gradually increases from a lower end of the at least one of the plurality of charge storage particles to an upper end of the at least one of the plurality of charge storage particles.

14. The method of claim 12 or 13, wherein
at least one of the plurality of charge storage particles includes a first curved surface facing the charge blocking layer and a second curved surface facing the channel layer, and
a first radius of curvature of the first curved surface is greater than a second radius of curvature of the second curved surface.

15. The method of any of claims 12 to 14, wherein at least one of the plurality of charge storage particles has a shape of a truncated sphere.
